# EUROPEAN PATENT APPLICATION

(11) **EP 2 604 638 A1**
(43) Date of publication of application: **19.06.2013**
(21) Application number: 11816291.6
(22) Date of filing: 20.07.2011
(51) Int. Cl.: C08G 59/20, H01L 23/29, H01L 23/31, H01L 31/02, H01L 33/56

(54) **CURABLE RESIN COMPOSITION AND CURED ARTICLE THEREOF**

(30) Priority: 10.08.2010 JP 2010179286
(71) Applicant: Daicel Chemical Industries, Ltd., Osaka-shi, Osaka 530-0001 (JP)
(72) Inventor: SATO, Atsushi, Ohtake-shi Hiroshima 739-0601 (JP)
(74) Representative: Grünecker, Kinkeldey, Stockmair & Schwanhäusser
(86) International application number: PCT/JP2011/066434
(87) International publication number: WO 2012/020625

(57) **Abstract**

A curable resin composition essentially includes an epoxy compound (A) having an oxycyclohexane skeleton including a cyclohexane ring and an epoxy group bound thereto through a single bond; an alicyclic epoxy compound (B) having two or more alicyclic epoxy groups per molecule; at least one bisphenol diepoxy compound (C) selected from bisphenol-A epoxy resins and bisphenol-F epoxy resins; a polyglycidyl ether of an aliphatic polyhydric alcohol (D); and a curing agent (E). The curable resin composition can give a cured article which has extremely superior moisture resistance, and, when used typically as an LED sealant, does not cause reduction in luminous flux even under hot and humid conditions. The cured article also has satisfactory cracking resistance and thermal stability in heat cycles.

## Description

### Technical Field

The present invention relates to curable resin compositions and cured articles derived therefrom, which are useful typically for sealing optical semiconductors; and to optical semiconductor devices including optical semiconductor elements sealed with the cured articles.

### Background Art

Epoxy resins have high transparency and are used as sealing resins for the sealing of optical semiconductor elements such as light-emitting diodes (LEDs); optical sensors; and light-emitting elements and light-receiving elements for optical communications.

Typically, Patent Literature (PTL) 1 (Japanese Examined Patent Application Publication (JP-B) No. H05-8928) discloses a sealant for optical elements, which essentially includes an epoxy resin having an oxycyclohexane skeleton including a cyclohexane ring and an epoxy ring bound to the cyclohexane ring through a single bond; and a curing agent. The sealant for optical element advantageously excels in moisture resistance, thermal stability, and mechanical properties.

PTL 2 (Japanese Unexamined Patent Application Publication (JP-A) No. 2005-171187) discloses a resin composition for sealing optical semiconductors, which contains an epoxy resin component including an alicyclic epoxy resin; and a curing accelerator component including an organic aluminum compound and a hydroxyl-containing organic silicon compound.

PTL 3 (Japanese Patent No. 4366934) discloses an optical module sealed with a transparent sealing material including epoxy resins, a curing catalyst, and an alcohol having a specific structure for more satisfactory fluidity, in which the epoxy resins are 3,4-epoxycyclohexylmethyl (3,4-epoxy)cyclohexane carboxylate and an adduct of 2,2-bis(hydroxymethyl)-1-butanol with 1,2-epoxy-4-(2-oxiranyl)cyclohexane.

### Citation List

### Patent Literature

PTL 1: JP-B No. H05-8928
PTL 2: JP-A No. 2005-171187
PTL 3: Japanese Patent No. 4366934

### Summary of Invention

### Technical Problem

Such customary sealants for optical elements, however, are not sufficiently satisfactory in industrial uses, because they disadvantageously suffer from cracking when undergoing heat cycles, fail to allow bubbles to escape upon sealing because of their high viscosities, or suffer from poor molding workability.
An object of the present invention is to provide a curable resin composition, a cured article derived therefrom, and an optical semiconductor device using the curable resin composition, in which the curable resin composition has satisfactory molding workability and can give a cured article which has remarkably superior moisture resistance and, when used typically as a sealant for an LED, does not cause reduction in luminous flux of the LED even under hot and humid conditions, and which has satisfactory cracking resistance and excellent thermal stability in heat cycles. Solution to Problem

After intensive investigations to achieve the object, the present inventors have found that a curable resin composition including specific four different epoxy compounds in combination can satisfy all the required properties. Specifically, the composition has satisfactory molding workability and gives a cured article which, when used typically as a sealant for an LED, does not cause reduction in luminous flux of the LED under hot and humid conditions and which has satisfactory cracking resistance and excellent thermal stability in heat cycles. The present invention has been made based on these findings.
Specifically, the present invention provides, in an aspect, a curable resin composition which includes an epoxy compound (A); an alicyclic epoxy compound (B) having two or more alicyclic epoxy groups per molecule; at least one bisphenol diepoxy compound (C) selected from the group consisting of bisphenol-A epoxy resins and bisphenol-F epoxy resins; a polyglycidyl ether of an aliphatic polyhydric alcohol (D); and a curing agent (E) as essential components,
in which the epoxy compound is represented by following Formula (I) : 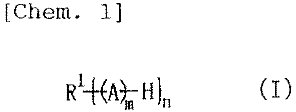 wherein R¹ represents an n-hydric alcohol residue; "A" represents a group represented by following Formula (a): 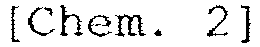 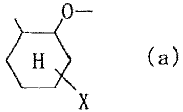 wherein X represents a group selected from groups represented by following Formulae (b), (c), and (d): 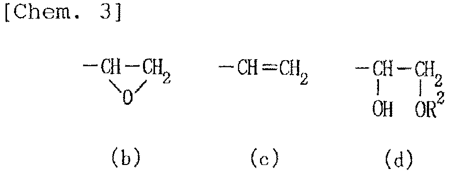 wherein R² represents hydrogen atom, an alkyl group, an alkylcarbonyl group, or an arylcarbonyl group; m denotes an integer of 0 to 30; and
n denotes an integer of 1 to 10, wherein, when n is 2 or more, groups in brackets in the number of n may be the same as or different from each other; when m is 2 or more, m"A"s may be the same or different from each other; and the group "A" is present in a total number of 1 to 100 per molecule, where at least one group "A" wherein X is the group represented by Formula (b) is present per molecule.

The present invention provides, in another aspect, a cured article derived from the curable resin composition.

In addition, the present invention provides an optical semiconductor device which includes an optical semiconductor element sealed with a cured article derived from the curable resin composition.

### Advantageous Effects of Invention

The present invention provides a curable resin composition including specific four different epoxy compounds in combination. The curable resin composition therefore can give a cured article which has extremely superior moisture resistance and, when used typically as a sealant for an optical semiconductor element, does not cause reduction in luminous flux of the optical semiconductor element even under hot and humid conditions and which does not suffer from cracking and exhibits satisfactory thermal stability even after heat cycles. The curable resin composition also has a low viscosity to exhibit satisfactory molding workability.

### Description of Embodiments

A curable resin composition according to an embodiment of the present invention essentially includes an epoxy compound (A) represented by Formula (I) (hereinafter also simply referred to as an "epoxy compound (A)"); an alicyclic epoxy compound (B) having two or more alicyclic epoxy groups per molecule (hereinafter also simply referred to as an "alicyclic epoxy compound (B)"); at least one bisphenol diepoxy compound (C) selected from the group consisting of bisphenol-A epoxy resins and bisphenol-F epoxy resins (hereinafter also simply referred to as a "bisphenol diepoxy compound (C)"); a polyglycidyl ether of an aliphatic polyhydric alcohol (aliphatic polyhydric alcohol polyglycidyl ether) (D); and a curing agent (E). These four different epoxy compounds, as used in combination, may help the curable resin composition to satisfactorily have all the properties including suppression of reduction in luminous flux under hot and humid conditions, cracking suppression and thermal stability in heat cycles, and molding workability.

### [Epoxy Compound (A) Represented by Formula (I)]

In Formula (I) representing the epoxy compound (A), R¹ represents an n-hydric alcohol residue (residue of an alcohol having a valency of n); and "A" represents a group represented by Formula (a). X in Formula (a) represents a group selected from the group consisting of groups respectively represented by Formulae (b), (c), and (d). R² in Formula (d) represents hydrogen atom, an alkyl group, an alkylcarbonyl group, or an arylcarbonyl group. In Formula (I), m denotes an integer of 0 to 30; and n denotes an integer of 1 to 10. When n is 2 or more, groups in brackets in the number of n may be the same as or different from each other. When m is 2 or more, m"A"s may be the same as or different from each other. A total number of "A" per molecule is 1 to 100. At least one (preferably three or more) "A" wherein X is the group represented by Formula (b) is present in the molecule. Each of different epoxy compounds (A) represented by Formula (I) may be used alone or in combination. The left-hand bond of "A" in Formula (a) is bound to an oxygen atom of the "n-hydric alcohol residue" as R¹ in Formula (I).

The n-hydric alcohol may be typified by monohydric alcohols such as methanol, ethanol, 1-propanol, isopropyl alcohol, 1-butanol, 1-pentanol, 1-hexanol, benzyl alcohol, and allyl alcohol; dihydric alcohols such as ethylene glycol, 1,2-propanediol, 1,3-propanediol, 1,3-butanediol, 1,4-butanediol, 1,5-pentanediol, neopentyl glycol, 1,6-hexanediol, diethylene glycol, triethylene glycol, tetraethylene glycol, polyethylene glycols, dipropylene glycol, polypropylene glycols, cyclohexanedimethanols, hydrogenated bisphenol-A, hydrogenated bisphenol-F, and hydrogenated bisphenol-S; and trihydric or higher alcohols such as glycerol, diglycerol, polyglycerols, erythritol, trimethylolethane, trimethylolpropane, pentaerythritol, dipentaerythritol, and sorbitol. The alcohol may also be any of polyether polyols, polyester polyols, polycarbonate polyols, and polyolefin polyols. The alcohol is preferably any of aliphatic alcohols having 1 to 10 carbon atoms, of which trimethylolpropane and other aliphatic polyhydric alcohols having 2 to 10 carbon atoms are more preferred.

As R², the alkyl group may be typified by alkyl groups having 1 to 6 carbon atoms, such as methyl and ethyl groups; the alkylcarbonyl group may be typified by alkyl-carbonyl groups whose alkyl moiety having 1 to 6 carbon atoms, such as acetyl and propionyl groups; and the arylcarbonyl group may be typified by aryl-carbonyl groups whose aryl moiety having 6 to 10 carbon atoms, such as benzoyl group.

The epoxy compound (A) represented by Formula (I) may be produced by subjecting 4-vinylcyclohexene-1-oxide to ring-opening polymerization with the n-hydric alcohol as an initiator to give a polyether resin, i.e., a polycyclohexene oxide polymer having vinyl side chains; and epoxidizing the vinyl side chains with an oxidizing agent such as a peracid (e.g., peracetic acid). The resulting epoxy compound (A) includes "A"s having a group represented by Formula (b) as X, "A"s having a group represented by Formula (c) as X, and "A"s having a group represented by Formula (d) as X in a varying abundance ratio depending on the production conditions. The vinyl group represented by Formula (c) is an unreacted vinyl group not undergoing epoxidation; and the group represented by Formula (d) is a group derived typically from a reaction solvent or peracid (see JP-B No. H04-10471).

The epoxy compound (A) represented by Formula (I) may also be a commercial product. Exemplary commercial products include trade name "EHPE3150" (Daicel Chemical Industries, Ltd. (former name of Daicel Corporation)).

### [Alicyclic Epoxy Compound (B) Having Two or More Alicyclic Epoxy Groups per Molecule]

As used herein the term "alicyclic epoxy group" in the alicyclic epoxy compound (B) having two or more alicyclic epoxy groups per molecule refers to an epoxy group constituted by an oxygen atom and, of carbon atoms constituting an alicycle, two adjacent carbon atoms. The alicyclic epoxy group may be typified by epoxycyclopentyl group, 3,4-epoxycyclohexyl group, and 3,4-epoxytricyclo[5.2.1.0^{2,6}]dec-8- (or -9-)yl group (epoxidized dicyclopentadienyl group).

The alicyclic epoxy compound (B) having two or more alicyclic epoxy groups per molecule may be typified by compounds represented by following Formula (II) (compounds each including two alicyclic epoxy groups bound to each other through a single bond or a linkage group). Each of different alicyclic epoxy compounds (B) may be used alone or in combination.

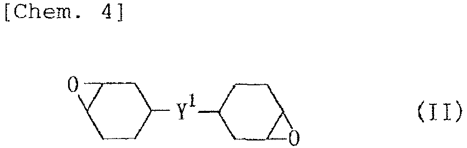

Y¹ in the formula represents a single bond or a linkage group. The linkage group may be typified by divalent hydrocarbon groups, carbonyl group (-CO-), ether bond (-O-), ester bond (-COO-), amide bond (-CONH-), carbonate bond (-OCOO-), and groups each including two or more of these bound to each other. Exemplary divalent hydrocarbon groups include linear or branched chain alkylene groups such as methylene, ethylidene, isopropylidene, ethylene, propylene, trimethylene, and tetramethylene groups, of which alkylene groups having 1 to 6 carbon atoms are preferred; divalent alicyclic hydrocarbon groups such as 1,2-cyclopentylene, 1,3-cyclopentylene, cyclopentylidene, 1,2-cyclohexylene, 1,3-cyclohexylene, 1,4-cyclohexylene, and cyclohexylidene groups, of which divalent cycloalkylene groups are preferred; and groups each including two or more of these bound to each other. Among them, ester bond (-COO-) is preferred as Y¹.

The compounds represented by Formula (II) are typified by the following compounds:

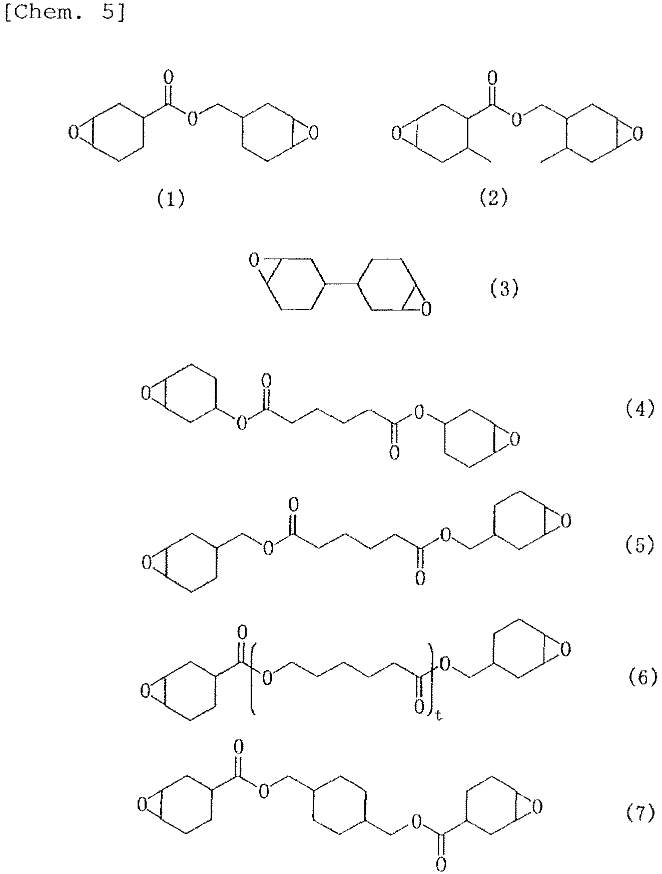

In the formula, t denotes an integer of 1 to 30.

The alicyclic epoxy compound (B) for use herein may also be any of alicyclic epoxy compounds each having three or more alicyclic epoxy groups per molecule, as indicated below. In the following formulae, the numbers a, b, c, d, e, and f are each independently an integer of 0 to 30.

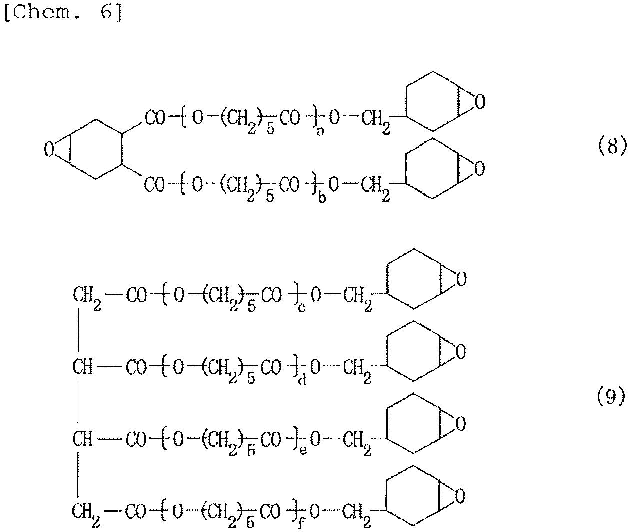

The alicyclic epoxy compound (B) having two or more alicyclic epoxy groups per molecule may also be any of Commercial products available typically under the trade name of "CEL2021P" (Daicel Chemical Industries, Ltd.).

### [Bisphenol Diepoxy Compound (C)]

The bisphenol diepoxy compound (C) for use in the present invention is at least one epoxy resin selected from the group consisting of bisphenol-A epoxy resins and bisphenol-F epoxy resins.

The bisphenol diepoxy compound (C) is also available as commercial products available typically under trade names of "EXA-850CRP," "EXA-830CRP," "EXA-830LVP," and "EXA-835LV" (each from DIC Corporation).

### [Aliphatic Polyhydric Alcohol Polyglycidyl Ether (D)]

The aliphatic polyhydric alcohol polyglycidyl ether (D) in the curable resin composition according to the present invention has the function of significantly reducing the viscosity of the curable resin composition while serving as an epoxy resin. This component therefore helps the curable resin composition to be remarkably improved in molding workability such as casting workability.

The "aliphatic polyhydric alcohol" moiety in the aliphatic polyhydric alcohol polyglycidyl ether (D) may be typified by dihydric alcohols such as ethylene glycol, 1,2-propanediol, 1,3-propanediol, 1,3-butanediol, 1,4-butanediol, 1,5-pentanediol, neopentyl glycol, 1,6-hexanediol, diethylene glycol, triethylene glycol, tetraethylene glycol, polyethylene glycols, dipropylene glycol, polypropylene glycols, and cyclohexanedimethanol; and trihydric or higher alcohols such as glycerol, diglycerol, polyglycerols, erythritol, trimethylolethane, trimethylolpropane, pentaerythritol, and dipentaerythritol. Such aliphatic polyhydric alcohols include aliphatic polyhydric alcohols containing an alicycle; and aliphatic polyhydric alcohols containing no alicycle. Each of different aliphatic polyhydric alcohol polyglycidyl ethers (D) may be used alone or in combination.

The aliphatic polyhydric alcohol polyglycidyl ether (D) is typified by 1,6-hexanediol diglycidyl ether, 1,4-butanediol diglycidyl ether, cyclohexanedimethanol diglycidyl ether, trimethylolpropane polyglycidyl ethers, diethylene glycol diglycidyl ether, neopentyl glycol diglycidyl ether, propylene glycol diglycidyl ether, polypropylene glycol diglycidyl ether, and polyethylene glycol diglycidyl ether.

The aliphatic polyhydric alcohol polyglycidyl ether (D) is also available as commercial products available typically under the trade name of "EPICLON 725" (from DIC Corporation); the trade names of "EX-212L," "EX-214L," "EX-216L," "EX-321L," and "EX-850L" (each from Nagase ChemteX Corporation); the trade name of "Rikaresin DME-100" (from New Japan Chemical Co., Ltd.); the trade names of "SR-NPG," "SR-16H," "SR-16HL," "SR-TMP," "SR-PG," "SR-TPG," "SR-4PG," "SR-2EG," "SR-8EG," "SR-8EGS," and "SR-GLG" (each from Sakamoto Yakuhin Kogyo Co., Lid.); and the trade names of "PG-207GS," "ZX-1658GS," and "ZX-1542" (each from Nippon Steel Chemical Co., Ltd.).

The aliphatic polyhydric alcohol polyglycidyl ether (D) may have a viscosity (25°C) of typically 5 to 1000 mPa.s, preferably 10 to 750 mPa.s, more preferably 10 to 500 mPa.s, and particularly preferably 10 to 200 mPa.s.

The curable resin composition according to the present invention may further include an epoxy compound (hereinafter also referred to as an "additional epoxy compound") other than the epoxy compound (A), the alicyclic epoxy compound (B), the bisphenol diepoxy compound (C), and the aliphatic: polyhydric alcohol polyglycidyl ether (D). The additional epoxy compound may be typified by bisphenol-S epoxy resins, biphenyl epoxy resins, phenol novolak epoxy resins, cresol novolak epoxy resins, heterocyclic epoxy resins (e.g., triglycidyl isocyanurate), glycidyl ester epoxy resins, epoxy compounds each having only one alicyclic epoxy group per molecule (e.g., limonene diepoxide), epoxidized products of oils and fats, and epoxidized products of polyolefins or polyalkadienes (e.g., epoxidized polybutadienes).

The curable resin composition according to the present invention may include the epoxy compound (A), the alicyclic epoxy compound (B), the bisphenol diepoxy compound (C), and the aliphatic polyhydric alcohol polyglycidyl ether (D) in a total amount of preferably 70 percent by weight or more, more preferably 85 percent by weight or more, and particularly preferably 95 percent by weight or more, based on the total amount of entire epoxy compounds [total of the epoxy compound (A), alicyclic epoxy compound (B), bisphenol diepoxy compound (C), aliphatic polyhydric alcohol polyglycidyl ether (D), and additional epoxy compounds].

The curable resin composition according to the present invention may contain the epoxy compound (A) in an amount of typically 5 to 60 percent by weight, preferably 10 to 55 percent by weight, and more preferably 20 to 50 percent by weight, based on the total amount of the epoxy compound (A), the alicyclic epoxy compound (B), the bisphenol diepoxy compound (C), and the aliphatic polyhydric alcohol polyglycidyl ether (D). The curable resin composition, if containing the epoxy compound (A) in an excessively small amount, may give a cured article liable to suffer from reduction in luminous flux under hot and humid conditions; and the curable resin composition, if containing the epoxy compound (A) in an excessively large amount, may have an excessively high viscosity to impede escaping of bubbles or to cause inferior molding workability.

The curable resin composition may contain the alicyclic epoxy compound (B) in an amount of typically 5 to 80 percent by weight, preferably 10 to 70 percent by weight, and more preferably 15 to 55 percent by weight, based on the total amount of the epoxy compound (A), the alicyclic epoxy compound (B), the bisphenol diepoxy compound (C), and the aliphatic polyhydric alcohol polyglycidyl ether (D). The curable resin composition, if containing the alicyclic epoxy compound (B) in an excessively small amount, may give a cured article liable to have insufficient thermal stability; and the curable resin composition, if containing the alicyclic epoxy compound (B) in an excessively large amount, may give a cured article which is liable to cause reduction in luminous flux under hot and humid conditions or which often suffers from cracking as a result of heat cycles.

The curable resin composition may contain the bisphenol diepoxy compound (C) in an amount of typically 5 to 60 percent by weight, preferably 8 to 50 percent by weight, and more preferably 10 to 40 percent by weight, based on the total amount of the epoxy compound (A), the alicyclic epoxy compound (B), the bisphenol diepoxy compound (C), and the aliphatic polyhydric alcohol polyglycidyl ether (D). The curable resin composition, if containing the bisphenol diepoxy compound (C) in an excessively small amount, may give a cured article liable to suffer from cracking as a result of heat cycles; and the curable resin composition, if containing the bisphenol diepoxy compound (C) in an excessively large amount, may give a cured article liable to cause reduction in luminous flux under hot and humid conditions.

The curable resin composition may contain the aliphatic polyhydric alcohol polyglycidyl ether (D) in an amount of typically 3 to 50 percent by weight, preferably 4 to 40 percent by weight, and more preferably 5 to 30 percent by weight, based on the total amount of the epoxy compound (A), the alicyclic epoxy compound (B), the bisphenol diepoxy compound (C), and the aliphatic polyhydric alcohol polyglycidyl ether (D). The curable resin composition, if containing the aliphatic polyhydric alcohol polyglycidyl ether (D) in an excessively small amount, may have an excessively high viscosity to impede escaping of bubbles or to exhibit insufficient molding workability; and the curable resin composition, if containing the aliphatic polyhydric alcohol polyglycidyl ether (D) in an excessively large amount, may often give a cured article having insufficient thermal stability.

When mixed in a compositional ratio for the preparation of the curable resin composition according to the present invention, a mixture of the epoxy compound (A), the alicyclic epoxy compound (B), the bisphenol diepoxy compound (C), and the aliphatic polyhydric alcohol polyglycidyl ether (D) may have a viscosity (25°C) of typically 500 to 50000 mPa.s, preferably 800 to 30000 mPa.s, and more preferably 1000 to 20000 mPa.s. The curable resin composition, when having an excessively high viscosity of the mixture, may be liable to have insufficient molding workability (e.g., casting workability).

### [Curing Agent (E)]

The curing agent (E) can be any acid anhydride. The acid anhydride may be any of curing agents generally used for epoxy compounds, but is preferably one being liquid at room temperature, which is typified by methyltetrahydrophthalic anhydride, methylhexahydrophthalic anhydride, dodecenylsuccinic anhydride, and methyl-endomethylene-tetrahydrophthalic anhydride. Any of acid anhydrides being solid at room temperature may be used within a range not adversely affecting molding workability. These acid anhydrides are typified by phthalic anhydride, tetrahydrophthalic anhydride, hexahydrophthalic anhydride, and methylcyclohexenedicarboxylic anhydride. Such an acid anhydride solid at room temperature, when used, is preferably used as a mixture which is liquid at room temperature and is prepared by dissolving the solid acid anhydride in an acid anhydride being liquid at room temperature. Each of different curing agents (E) may be used alone or in combination.

The curing agent (E) may also be any of commercial products available typically under the trade name of "Rikacid MH700" (New Japan Chemical Co., Ltd.); and the trade name of "HN-5500" (Hitachi Chemical Co., Ltd.).

The curable resin composition according to the present invention may contain the curing agent (E) in an amount of typically 10 to 300 parts by weight, preferably 30 to 200 parts by weight, and more preferably 50 to 150 parts by weight, per 100 parts by weight of the total amount of entire epoxy compounds contained in the curable resin composition [or the total amount of the epoxy compound (A), the alicyclic epoxy compound (B), the bisphenol diepoxy compound (C), and the aliphatic polyhydric alcohol polyglycidyl ether (D)]. More specifically, the curing agent (E) is preferably used in an amount of 0.5 to 1.5 equivalents per equivalent of epoxy groups of entire epoxy compounds contained in the curable resin composition. The curable resin composition, if containing the curing agent (E) in an excessively small amount, may suffer from insufficient curing and may give a cured article having insufficient toughness; and the curable resin composition, if containing the curing agent (E) in an excessively large amount, may give a colored cured article having inferior hue.

### [Other Components]

The curable resin composition according to the present invention preferably further includes a curing accelerator for accelerating curing of epoxy compounds. The curing accelerator is not limited, as long as one used for accelerating curing of epoxy compounds, and is typified by diazabicycloundecene curing accelerators such as 1,8-diazabicyclo[5.4.0]undecene-7 (DBU) and salts thereof (e.g., p-toluenesulfonic acid salt and octanoic acid salt); tertiary amines such as benzyldimethylamine and 2,4,6-tris (dimethylaminomethyl)phenol; imidazoles such as 2-ethyl-4-methylimidazole and 1-cyanoethyl-2--ethyl-4-methylimidazole; organic phosphine compounds such as triphenylphosphine; tertiary amine salts; quaternary ammonium salts; quaternary phosphonium salts; organic metal salts such as tin octylate, dibutyltin dilaurate, and zinc octylate; and boron compounds. Of these curing accelerators, diazabicycloundecene curing accelerators are preferred. Each of different curing accelerators may be used alone or in combination.

The curing accelerator for use herein may also be any of commercial products available typically under the trade names of "U-CAT SA-506" and "U-CAT SA-102" (each from San-Apro Ltd.).

The curable resin composition may contain a curing accelerator(s) in an amount of typically 0.01 to 15 parts by weight, preferably 0.1 to 10 parts by weight, and more preferably 0.5 to 8 parts by weight, per 100 parts by weight of the total amount of entire epoxy compounds contained in the curable resin composition [or the total amount of the epoxy compound (A), the alicyclic epoxy compound (B), the bisphenol diepoxy compound (C), and the aliphatic polyhydric alcohol polyglycidyl ether (D)]. The curable resin composition, if containing a curing accelerator in an excessively small amount, may not undergo sufficiently accelerated curing; and, if containing a curing accelerator in an excessively large amount, may give a cured article with inferior hue.

The curable resin composition according to the present invention may further include any of additives according to necessity. A hydroxyl-containing compound (e.g., polyhydric alcohol), such as ethylene glycol, diethylene glycol, propylene glycol, or glycerol, is preferably used as the additive, for allowing a reaction to proceed moderately. The curable resin composition may contain such a hydroxyl - containing compound (e.g., polyhydric alcohol) in an amount of typically 0.1 to 10 parts by weight, and preferably 0.5 to 5 parts by weight, per 100 parts by weight of the curing agent (E).

The curable resin composition may include, as an additive, an ester (e.g., diester) of a polycarboxylic anhydride (e.g., alicyclic polycarboxylic anhydride) with a polyhydric alcohol (e.g., polyalkylene glycol) so as to give a cured article with better flexibility. The curable resin composition may contain the ester in an amount of typically 0.1 to 10 parts by weight, and preferably 0.5 to 8 parts by weight, per 100 parts by weight of the total amount of entire epoxy compounds contained in the curable resin composition [or the total amount of the epoxy compound (A), the alicyclic epoxy compound (B), the bisphenol diepoxy compound (C), and the aliphatic polyhydric alcohol polygiycidyl ether (D)].

The curable resin composition may further include other additives according to necessity, within ranges not adversely affecting viscosity of the curable resin composition and transparency of the cured article. Such other additives are typified by silicone- or fluorine-containing defoaming agents, leveling agents, silane coupling agents, surfactants, inorganic fillers, organic rubber particles, flame retardants, colorants, plasticizers, antistatic agents, releasing agents, antioxidants, ultraviolet absorbers, photostabilizers, ion adsorbents, pigments, dyestuffs, and phosphors. The curable resin composition may contain these additives in an amount of typically 5 percent by weight or less based on the total amount of the curable resin composition. The curable resin composition according to the present invention may include a solvent. However, the curable resin composition, if containing a solvent in an excessively large amount, may cause bubbles in the cured article. To avoid this, the curable resin composition may contain a solvent in an amount of preferably 10 percent by weight or less, and particularly preferably 1 percent by weight or less, based on the total amount of the curable resin composition.

The curable resin composition according to the present invention may contain the curing agent and other components in a total amount of preferably 70 to 150 parts by weight, and more preferably 80 to 130 parts by weight, per 100 parts by weight of the total amount of epoxy compounds.

The curable resin composition according to the present invention has a viscosity (25°C) of typically 50 to 1800 mPa.s, preferably 100 to 1600 mPa.s, and more preferably 200 to 1500 mPa.s. The curable resin composition, if having an excessively high viscosity, may impede escaping of bubbles and may often be inferior in molding workability (e.g., sealing workability and casting workability).

The curable resin composition according to the present invention may be produced typically by mixing epoxy compounds, i.e., the epoxy compound (A), alicyclic epoxy compound (B), bisphenol diepoxy compound (C), aliphatic polyhydric alcohol polyglycidyl ether (D), and one or more optionally epoxy compounds according to necessity to prepare a mixture A; mixing the curing agent with other optional components (e.g., curing accelerator) to prepare a mixture B; mixing the mixture A with the mixture B in a predetermined ratio with stirring; and subjecting the resulting mixture to debubbling (degassing) in vacuo. Though the order of addition of respective components in the preparation of the mixture A is not limited, a homogeneous composition (mixture) can be efficiently prepared by initially mixing the alicyclic epoxy compound (B) with the bisphenol diepoxy compound (C); adding the epoxy compound (A) thereto; and subsequently adding the aliphatic polyhydric alcohol polyglycidyl ether (D) thereto. The mixing and stirring to give the mixture A may be performed at a temperature of typically 30°C to 150°C, and preferably 35 to 130°C. The mixing and stirring to give the mixture B may be performed at a temperature of typically 30°C to 150°C, and preferably 35°C to 100°C. The mixing and stirring may be performed using a known device such as a planetary centrifugal mixer, planetary mixer, kneader, or dissolver.

### [Cured Article]

The curable resin composition according to the present invention gives a cured article by placing the composition in a desired place or die and curing the composition. The curing may be performed at a temperature of typically 45°C to 200°C, preferably 80°C to 190°C, and more preferably 100°C to 180°C. The curing may be performed for a duration of typically 30 to 600 minutes, preferably 45 to 540 minutes, and more preferably 60 to 480 minutes.

The cured article has a glass transition temperature of preferably 120°C or higher, and more preferably 140°C or higher.

### [Optical Semiconductor Device]

An optical semiconductor device according to an embodiment of the present invention includes an optical semiconductor element sealed with a cured article derived from the curable resin composition according to the present invention.

The optical semiconductor element may be typified by light-emitting diodes; optical sensors; and light-emitting elements and light-receiving elements for optical communication. The optical semiconductor element may be sealed typically by placing the same in a predetermined forming die, casting the curable resin composition into the forming die (or casting the curable resin composition into a forming die and placing the optical semiconductor element in the die), and heating and thereby curing the curable resin composition under predetermined conditions. The curing conditions are as above.

The curable resin composition according to the present invention has a low viscosity and exhibits extremely good molding workability (e.g., sealing workability and casting workability). The curable resin composition can give a cured article which is stable in luminous flux even under hot and humid conditions and much less suffers from cracking even after repeated heat cycles. In addition, the cured article has a high glass transition temperature and is satisfactorily thermally stable. This stably provides optical semiconductor devices with very high reliability.

### EXAMPLES

The present invention will be illustrated in further detail below with reference to several working examples, which are never construed to limit the scope of the invention.

### EXAMPLE 1

Initially, 20 parts by weight of trade name "CEL2021P" (Daicel Chemical Industries, Ltd.; 3,4-epoxycyclohexylmethyl 3,4-epoxy)cyclohexane carboxylate) and 20 parts by weight of trade name "EXA-850CRP" (DIC Corporation; bisphenol-A epoxy resin) were mixed with each other with stirring at 80°C for 30 minutes. To the resulting mixture was added 40 parts by weight of trade name "EHPE3150" [Daicel Chemical Industries, Ltd.; an adduct of 2,2-bis(hydroxymethyl)-1-butanol with l,2-epoxy-4-(2-oxiranyl)cyclohexane], followed by mixing with stirring at 100°C for one hour. The mixture was cooled to 45°C, combined with 20 parts by weight of trade name "EPICLON 725" (DIC Corporation; trimethylolpropane triglycidyl ether) to give a mixture A. The mixture A had a viscosity (25°C) of 14340 mPa.s.
Independently, 104.3 parts by weight of trade name "MH700" (New Japan Chemical Co., Ltd.; a 70:30 mixture of 4-methylhexahydrophthalic anhydride and hexahydrophthalic anhydride) was adjusted to a temperature of 40°C to 80°C, this was combined with 1.6 parts by weight of ethylene glycol, 0.5 part by weight of trade name "U-CAT SA-506" (San-Apro Ltd.; p-toluenesulfonic acid salt of 1,8-diazabicyclo[5.4.0]undecene-7), and 0.5 part by weight of trade name "U-CAT SA-102" (San-Apro Ltd.; octanoic acid salt of 1,8-diazabicyclo[5.4.0]undecene-7), mixed with them with stirring for 30 minutes, further combined with 3.1 parts by weight of trade name "HF-08" (New Japan Chemical Co., Ltd.; ester between an alicyclic acid anhydride and a polyalkylene glycol), followed by mixing them with stirring for 30 minutes to give a mixture B. The mixture B had a viscosity (25°C) of 149 mPa.s.
The mixture A and the mixture B were uniformly mixed with each other with debubbling using trade name "AWATORIRENTARO (Thinky Mixer)" (THINKY CORPORATION) and yielded a curable resin composition. The resulting curable resin composition was cast into a die (in a "lamp" shape, with a size of 5 in diameter), a lead frame bearing a red light-emitting diode (LED) element was inserted thereinto, followed by curing in an oven at 110°C for 2 hours. A cured article was retrieved from the die, further cured in an oven at 140°C for 3 hours, and yielded an optical semiconductor device.

### EXAMPLES 2 to 5 and COMPARATIVE EXAMPLES 1 to 7

Optical semiconductor devices were prepared by the procedure of Example 1, except for using respective material components in different amounts as given in Table 1.

### Evaluation Tests

The optical semiconductor devices obtained in the examples and comparative examples were examined on the following evaluations. The results are indicated in Table 1, in which numerics in the respective material components are amounts of them indicated in part by weight.

### [LED Power-on Test]

An initial total luminous flux of an LED of a sample optical semiconductor device was measured using an LED test & measurement system (trade name "OL-771"; Optronic Laboratories, Inc.). The optical semiconductor device was then placed in a thermo-hygrostat, through which a current of 40 mA was passed at an ambient temperature of 85°C and relative humidity of 85% to light the LED. A total luminous flux of the LED after lighting for 500 hours was measured, and a retention with respect to the initial total luminous flux was determined and indicated in percentage (%).
A sample having a retention of 90% or more after 500-hours lighting was evaluated as passed (Pass), and a sample having a retention of less than 90% was evaluated as failed (Fail).

### [Heat Shock Test]

A sample optical semiconductor device was placed in a heat shock tester (trade name "TSE-11-A"; ESPEC Corporation) and subjected to 500 cycles of a heat shock test, and how much cracks were formed was visually observed. The sample was exposed to a temperature of -40°C for 15 minutes and exposed to a temperature of 120°C for 15 minutes in one cycle (and then exposed to a temperature of -40°C for 15 minutes in a subsequent cycle), and this cycle ("exposure to -40°C for 15 minutes and then exposure to 120°C for 15 minutes") was repeated 500 times.
A sample, in which two or less out of five LEDs suffered from cracking, was evaluated as passed (Pass), and a sample, in which three or more out of five LEDs suffered from cracking, was evaluated as failed (Fail).

### [Glass Transition Temperature]

The sealant (cured article) was cut from the tip of the sealed LED to give a specimen. The specimen was thermomechanically analyzed at temperatures rising from room temperature to 300°C at a rate of temperature rise of 5°C/min using a thermo-mechanical analyzer (trade name "EXSTAR TMA/SS6000"; SII NanoTechnology Inc.). A glass transition temperature Tg of the specimen sealant was determined from a turning point (point of variation) in a thermo-mechanical analysis (TMA) curve. A sample having a glass transition temperature of 120°C or higher was evaluated as passed (Pass); and a sample having a glass transition temperature of lower than 120°C was evaluated as failed (Fail).

### [Viscosity of Composition]

The mixture A and the mixture B were mixed with each other using the trade name "AWATORIRENTARO (Thinky Mixer)" (THINLY CORPORATION) to give a composition, and a viscosity of the composition was measured with an E-type viscometer at 25°C. A sample having a viscosity in this measurement of 1500 mPa.s or more (particularly 1800 mPa.s or more) may often disadvantageously suffer from insufficient debubbling or poor casting workability.

As is demonstrated in Table 1, the curable resin compositions according to Examples 1 to 5 employing all the epoxy compound (A), alicyclic epoxy compound (B), bisphenol diepoxy compound (C), and aliphatic polyhydric alcohol polyglycidyl ether (D) satisfied all the required properties. Specifically, the curable resin compositions gave cured articles which provided satisfactory luminous flux stability under hot and humid conditions, and less suffered from cracking and were thermally stable in heat cycles. The curable resin compositions also had good molding workability. In contrast, samples, if lacking even one of the four material components as in Comparative Example 1 to 7, were insufficient in one or more of the required properties.

[Table 1]

**TABLE 1**

| | | Examples | | | | | Comparative Examples | | | | | | |
|---|---|---|---|---|---|---|---|---|---|---|---|---|---|
| | | 1 | 2 | 3 | 4 | 5 | 1 | 2 | 3 | 4 | 5 | 6 | 7 |
| Mixture A | EHPE3150 | 40 | 30 | 20 | 30 | 30 | 0 | 0 | 50 | 0 | 30 | 30 | 50 |
| | CEL2021 P | 20 | 30 | 40 | 30 | 30 | 100 | 0 | 50 | 60 | 0 | 60 | 20 |
| | EXA-850CRP | 20 | 30 | 30 | 30 | 30 | 0 | 100 | 0 | 30 | 30 | 0 | 30 |
| | EPICLQN 725 | 20 | 10 | 10 | 10 | 10 | 0 | 0 | 0 | 10 | 40 | 10 | 0 |
| Viscosity | (mPa.s) | 14340 | 8180 | 2480 | 8360 | 8220 | 226 | 4130 | 46600 | 427 | 4390 | 2450 | ≥100000 |
| Mixture B | MH700 | 104.3 | 104.3 | 104.3 | 85.3 | 123.2 | 104.3 | 104.3 | 104.3 | 104.3 | 104.3 | 104.3 | 104.3 |
| | Ethylene glycol | 1.6 | 1.6 | 1.6 | 1.3 | 1.8 | 1.6 | 1.6 | 1.6 | 1.6 | 1.6 | 1.6 | 1.6 |
| | HF-08 | 3.1 | 3.1 | 3.1 | 2.6 | 3.7 | 3.1 | 3.1 | 3.1 | 3.1 | 3.1 | 3.1 | 3.1 |
| | U-CATSA-506 | 0.5 | 0,5 | 0.5 | 0.4 | 0.6 | 0.5 | 0.5 | 0.5 | 0.5 | 0.5 | 0.5 | 0.5 |
| | U-CATSA-102 | 0.5 | 0.5 | 0,5 | 0.4 | 0.6 | 0.5 | 0.5 | 0.5 | 0.5 | 0.5 | 0.5 | 0.5 |
| Viscosity | (mPa.s) | 149 | 149 | 149 | 149 | 149 | 149 | 149 | 149 | 149 | 149 | 149 | 149 |
| Concentration of EHPE3150 in Mixture A (weight %) | | 40 | 30 | 20 | 30 | 30 | 0 | 0 | 50 | 0 | 30 | 30 | 50 |
| Weight ratio of Mixture B to Mixture A | | 1.1 | 1.1 | 1.1 | 0.9 | 1.3 | 1.1 | 1.1 | 1.1 | 1.1 | 1.1 | 1.1 | 1.1 |
| LED power-on test | | Pass | Pass | Pass | Pass | Pass | Fail | Fail | Pass | Fail | Pass | Pass | Pass |
| Heat shock test | | Pass | Pass | Pass | Pass | Pass | Fail | Pass | Fail | Pass | Pass | Fail | Pass |
| Glass transition temperature | | Pass | Pass | Pass | Pass | Pass | Pass | Pass | Pass | Pass | Fail | Pass | Pass |
| Viscosity of composition (mPa.s) | | 1383 | 1005 | 574 | 1180 | 810 | 200 | 641 | 1785 | 266 | 830 | 656 | 2800 |

### Industrial Applicability

Curable resin compositions according to the present invention employ specific four different epoxy compounds in combination and give cured articles with extremely superior moisture resistance. The cured articles, when used as sealants for optical semiconductor elements, do not cause reduction in luminous flux of the optical semiconductor elements even under hot and humid conditions, do not suffer from cracking and are satisfactorily thermally stable even in heat cycles. In addition, the curable resin compositions have low viscosities and exhibit excellent molding workability.

## Claims

1. A curable resin composition comprising:
an epoxy compound (A); an alicyclic epoxy compound (B) having two or more alicyclic epoxy groups per molecule; at least one bisphenol diepoxy compound (C) selected from the group consisting of bisphenol-A epoxy resins and bisphenol-F epoxy resins; a polyglycidyl ether of an aliphatic polyhydric alcohol (D); and a curing agent (E) as essential components,
the epoxy compound represented by following Formula (I) : 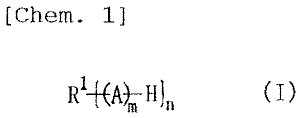 wherein R¹ represents an n-hydric alcohol residue;
"A" represents a group represented by following Formula (a): 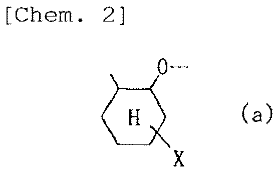 wherein X represents a group selected from groups represented by following Formulae (b), (c), and (d): 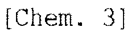 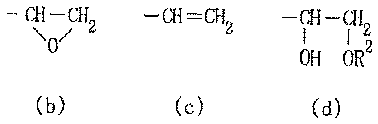 wherein R² represents hydrogen atom, an alkyl group, an alkylcarbonyl group, or an arylcarbonyl group;
m denotes an integer of 0 to 30; and
n denotes an integer of 1 to 10, wherein, when n is 2 or more, groups in brackets in the number of n may be the same as or different from each other; when m is 2 or more, m"A"s may be the same or different from each other; and the group "A" is present in a total number of 1 to 100 per molecule, where at least one group "A" wherein X is the group represented by Formula (b) is present per molecule.

2. A cured article derived from the curable resin composition of claim 1.

3. An optical semiconductor device comprising an optical semiconductor element sealed with a cured article derived from the curable resin composition of claim 1.
